# EUROPÄISCHE PATENTANMELDUNG

(11) **EP 3 829 065 A1**
(43) Veröffentlichungstag der Anmeldung: **02.06.2021**
(21) Anmeldenummer: 20209797.8
(22) Anmeldetag: 25.11.2020
(51) Int. Cl.: H03K 17/955

(54) **KAPAZITIVE SENSOREINRICHTUNG SOWIE VERFAHREN ZUR ERKENNUNG EINER OBJEKTANNÄHERUNG**

(30) Priorität: 29.11.2019 DE 102019132508
(71) Anmelder: Reime, Gerd, 77815 Bühl (DE)
(72) Erfinder: Reime, Gerd, 77815 Bühl (DE)
(74) Vertreter: RPK Patentanwälte Reinhardt, Pohlmann und Kaufmann Partnerschaft mbB

(57) **Zusammenfassung**

Eine kapazitive Sensoreinrichtung sowie ein Verfahren sind zur Erkennung der Annäherung und/oder Position wenigstens eines Objekts (5.1) geeignet. Dazu ist wenigstens einer Messelektrode (1.15) an einem sensoraktiven Bereich Vorgesehen. Mittels einer Ansteuereinrichtung (1.19) wird die Messelektrode (1.15) mit einer von einer Versorgungsspannung (1.9) abgeleiteten Spannung unter Erzeugung eines elektrischen Feldes angesteuert, das ausgehend von der Messelektrode in den sensoraktiven Bereich (3.4) ist. Eine von der Ansteuereinrichtung (1.19) betätigbare Schalteinrichtung (1.3) ist zur Erzeugung des elektrischen Felds mit der Messelektrode wirkverbunden. Eine Auswerteeinrichtung (1.20) ist zur Auswertung der von der Messelektrode (1.15) erzeugten Änderungen infolge der Bewegung und/oder Anwesenheit des Objekts (5.1) im sensoraktiven Bereich vorgesehen. Zwischen der Spannungsquelle und der Schalteinrichtung (1.3) ist wenigstens eine Induktivität (1.4) angeordnet und die Ansteuereinrichtung (1.19) ist dazu eingerichtet, die Schalteinrichtung (1.3) so anzusteuern, dass infolge der Induktivität (1.4) beim Abschalten eines Stroms durch die Induktivität mittels der Schalteinrichtung (1.3) ein Rückschlagimpuls (1.5) mit hochfrequenten Spektralanteilen entsteht. Dadurch, dass der Rückschlagimpuls (1.5) eine Spannung an der Messelektrode erzeugt, die höher als die Versorgungsspannung ist, und dass der wenigstens einen Messelektrode (1.15) wenigstens ein Ladungsspeicher (1.13, 1.14) und wenigstens ein Ladungs-Ableitwiderstand (1.16) nachgeschaltet sind, die dazu bestimmt und geeignet sind, die nach einem Rückschlagimpuls (1.5) anstehende Ladung durch die Auswerteeinrichtung (1.20) eines Microcontrollers (1.1) zu erfassen, wird ein empfindlicher kapazitiver Annäherungs- oder Positionssensor geschaffen, der insbesondere nicht auf Feuchtigkeit, feuchte Verschmutzung, fließendes Wasser oder ein Überwischen mit einem feuchten Lappen reagiert.

## Beschreibung

Die Erfindung betrifft eine kapazitive Sensoreinrichtung sowie ein Verfahren zur Erkennung der Annäherung und/oder Position eines Objekts nach dem Oberbegriff der Ansprüche 1 bzw. 10.

Kapazitive Sensoren, die in Sicherheitsleisten verbaut sind und schon z.B. eine Handannäherung detektieren, bevor die Hand eingeklemmt werden könnte, sind allgemein bekannt. Jedoch haben diese Systeme oftmals Schwierigkeiten, wenn Wasser direkt auf solche Systeme einwirkt, da Wasser, z.B. Regenwasser oder auch salzhaltiges Wasser das kapazitive Feld ähnlich wie ein Körperteil beeinflusst.

Weiterhin gibt es z.B. kapazitive Bedienfelder unter der Ceranfläche einer Kocheinrichtung, die bei Auflegen eines leitfähigen Gegenstandes, z.B. eines feuchten Lappens einen akustischen Alarm aktivieren, um eine Fehlbedienung zu verhindern.

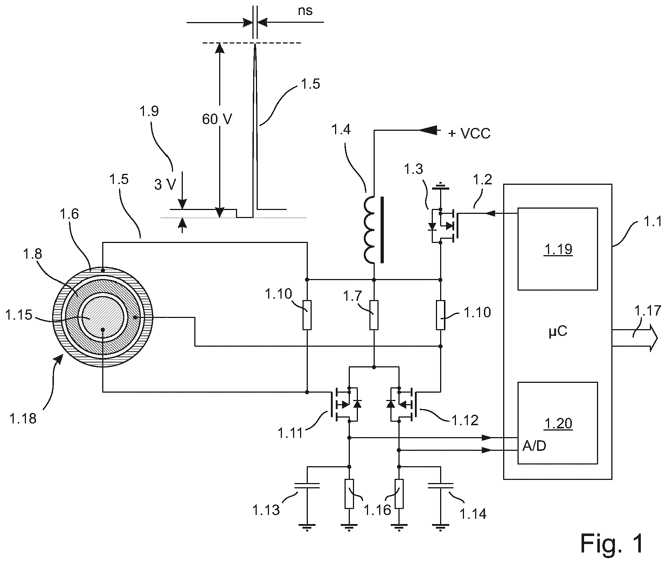

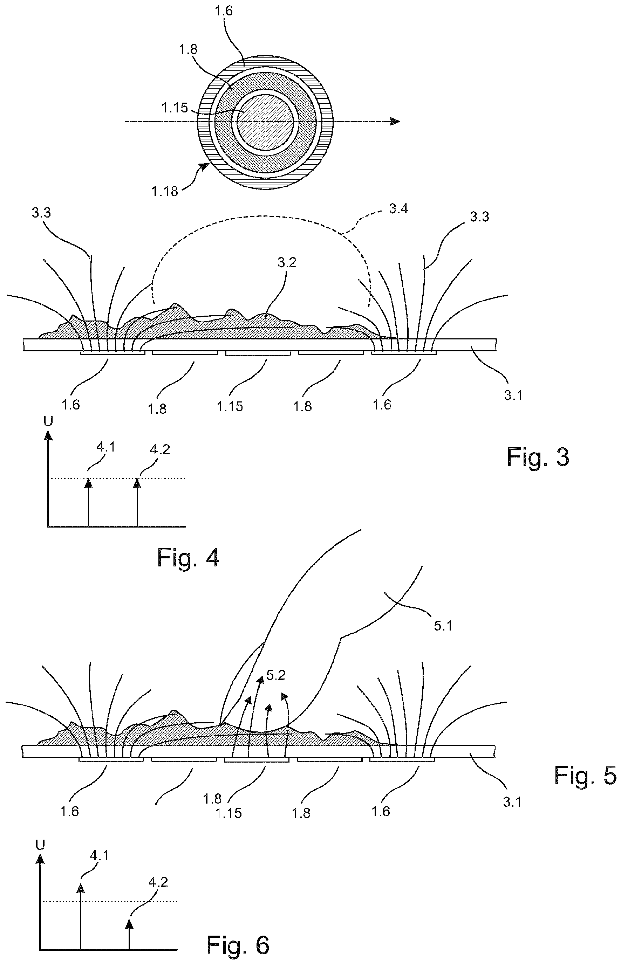

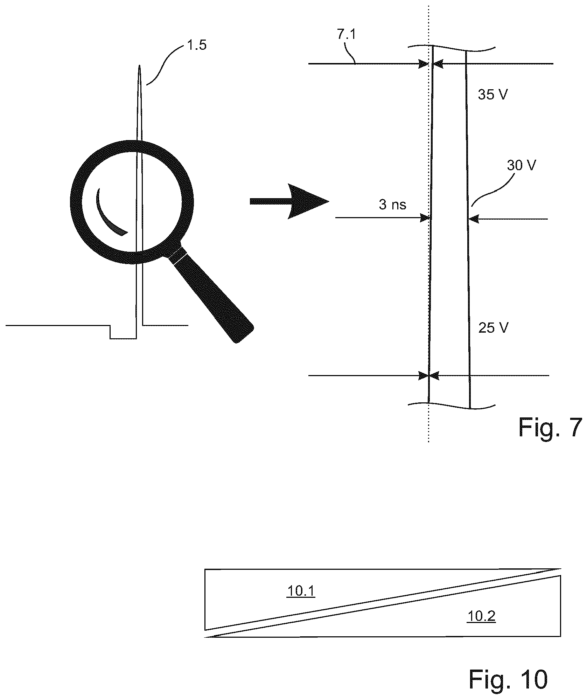

Aus der DE 10 2018 117 901 B3 ist ein feuchteunabhängiger kapazitiver Sensor für beliebige Schaltvorgänge bekannt, wird ein einem Impuls im weitesten Sinne entsprechendes Signal, welches einer Erregerschwingung entspricht, durch das Öffnen eines Schalters erzeugt, da eine Induktivität L den Strom aufrecht erhalten möchte. Das so entstandene Signal wird mittels Kondensatoren zu einem abklingenden Sinussignal geformt. Ein Frequenzgenerator ist dort durch einen Schwingkreis ersetzt. durch einen Schwingkreis ersetzt wird. Unserer Ansicht nach ist dies nicht der Fall, da es in jener Figur 7 gar keinen Frequenzgenerator 1.1 wie in Figur 1 oder Figur 3 der Erfindung gibt, sondern Dies könnte daher als eine mögliche Argumentation angeführt werden.

Aus der WO 2010/012480 A1 ist eine Vorrichtung zur kapazitiven Messung von Änderungen mit einem Sensor mit einem sensoraktiven Bereich bekannt. Der Sensor besitzt wenigstens eine ein elektrisches Feld erzeugende Sendeelektrode sowie eine weitere Elektrode, die kapazitiv an die Sendeelektrode gekoppelt ist. Die Sendeelektrode ist zwischen der weiteren Elektrode und einem auf einem Bezugspotenzial liegendem Element angeordnet ist. Ein Ausgang einer Auswerteeinheit ist mit der Sendeelektrode und ein Eingang der Auswerteeinheit hochohmig mit der weiteren Elektrode gekoppelt, wobei sich aufgrund des von der Sendeelektrode erzeugten elektrischen Felds zwischen Sendeelektrode und weiterer Elektrode ein elektrisches Feld zwischen weiterer Elektrode und dem Bezugspotenzial ausbildet.

Dadurch wird mittels der Auswerteeinheit eine Änderung der Kapazität zwischen weiterer Elektrode und Bezugspotenzial auch bei einem Belag oder einer Benetzung detektiert.

Wenn im Rahmen dieser Erfindung von der Erkennung der Annäherung und/oder Position eines "Objekts" die Rede ist, so kann es sich dabei gleichsam um Gegenstände oder Lebewesen handeln. In den Ausführungsbeispielen ist insbesondere von einem "Finger" als Objekt die Rede. Es können jedoch auch andere Objekte mit der Sensoreinrichtung detektiert werden.

Wenn im Rahmen dieser Erfindung von einer "Schalteinrichtung" die Rede ist, so handelt es sich dabei um jede Einrichtung, die dazu bestimmt und geeignet ist, Strom infolge eines Ansteuersignals zu schalten. Im Ausführungsbeispiel werden hierfür Schalttransistoren verwendet. Andere ansteuerbare Schalter sind jedoch ebenso geeignet, sofern mit ihnen zielgerichtet ein Strom zur Erzeugung eines Rückschlagimpulses geschaltet werden kann.

Aufgabe der Erfindung ist ein empfindlicher kapazitiver Annäherungs- oder Positionssensor, der insbesondere nicht auf Feuchtigkeit, feuchte Verschmutzung, fließendes Wasser oder ein Überwischen mit einem feuchten Lappen reagiert. Eine Funktion soll insbesondere nur bei bestimmungsmäßiger Bedienung, z.B. mit dem ausgestreckten Finger auf das Bedienelement, ausgelöst werden.

Diese Aufgabe wird mit einer kapazitiven Sensoreinrichtung mit den Merkmalen des Patentanspruchs 1 sowie durch ein Verfahren mit den Merkmalen des Anspruches 10 gelöst. Vorteilhafte Weiterbildungen sind Gegenstand der abhängigen Patentansprüche. Die in den Patentansprüchen einzeln aufgeführten Merkmale sind in technologisch sinnvoller Weise miteinander kombinierbar und können durch erläuternde Sachverhalte aus der Beschreibung und durch Details aus den Figuren ergänzt werden, wobei weitere Ausführungsvarianten der Erfindung aufgezeigt werden.

Die kapazitive Sensoreinrichtung ist dazu bestimmt und geeignet, die Annäherung und/oder Position wenigstens eines Objekts in einem sensoraktiven Bereich zu erkennen. Sie weist eine Spannungsquelle zum Bereitstellen einer Versorgungsspannung, wenigstens eine Messelektrode am sensoraktiven Bereich und eine Ansteuereinrichtung auf zum Ansteuern der Messelektrode mit einer von der Versorgungsspannung abgeleiteten Spannung unter Erzeugung eines elektrischen Feldes ausgehend von der Messelektrode in den sensoraktiven Bereich. Von der Ansteuereinrichtung ist eine Schalteinrichtung betätigbar, die zur Erzeugung des elektrischen Felds mit der Messelektrode wirkverbunden ist. Ferner ist eine Auswerteeinrichtung zur Auswertung der von der Messelektrode gemessenen Änderungen infolge der Bewegung und/oder Anwesenheit des Objekts im sensoraktiven Bereich vorgesehen.

Bei dieser Sensoreinrichtung wird zwischen der Spannungsquelle und der Schalteinrichtung wenigstens eine Induktivität vorgesehen. Wird nun mittels der Ansteuereinrichtung die Schalteinrichtung betätigt, ergibt sich infolge der Induktivität beim Abschalten des Stroms ein Rückschlagimpuls mit hochfrequenten Spektralanteilen, der eine Spannung an der Messelektrode erzeugt, die höher als die Versorgungsspannung ist. Diese hohen Frequenzanteile durchdringen leicht eine feuchte Verschmutzung sowie Wasser und auch salzhaltiges Wasser. Damit wird insbesondere ein empfindlicher kapazitiver Annäherungs- oder Positionssensor geschaffen, der unter Ausnutzung mehrere Elektroden nicht auf Feuchtigkeit, feuchte Verschmutzung, fließendes Wasser oder ein Überwischen mit einem feuchten Lappen reagiert.

Der wenigstens einen Messelektrode sind wenigstens ein Ladungsspeicher und wenigstens ein Ladungs-Ableitwiderstand nachgeschaltet, so dass ein Microcontroller die nach einem Rückschlagimpuls anstehende Ladung auch erfassen kann. Die Ladungsspeicher sind nämlich zusammen mit den Ladungs-Ableitwiderständen so dimensioniert, dass der Microcontroller genügend Zeit hat, die nach einem Rückschlagimpuls anstehende Ladung zu erfassen. Die Kapazitätswerte der Ladungsspeicher liegen vorzugsweise im Bereich einiger pF, während die Widerstandswerte der Ableitwiderstände vorzugsweise im Bereich von einigen zig Kilo-Ohm liegen.

Weiterhin soll dieser Sensor z.B. für standardmäßige taktile Sicherheitsleisten einsetzbar sein. Diese standardmäßigen Sicherheitsleisten sind mit einem Abschlusswiderstand ausgerüstet, der im Bereich einiger hundert Ohm bis wenige Kilo-Ohm liegt. Der Abschlusswiderstand wird verwendet, um eine mechanische Unterbrechung der Elektroden durch Unterbrechung eines Stromflusses in den Leisten zu erkennen.

Der kapazitive Sensor muss also so ausgelegt sein, das er mit einer großen Bandbreite von Abschlusswiderständen zurechtkommt. Dies hat den Vorteil, dass bereits im Markt befindliche taktile Sicherheitsleisten ohne Veränderung ihrer taktilen Funktion nun zusätzlich eine Annäherungsfunktion erhalten können.

Da diese Sicherheitsleisten in Fahrzeugen, insbesondere an Heckklappen und Fenstern verbaut sind, darf Wasser, wie z.B. salzhaltiges Spritzwasser, Betauung, Regen oder auch feuchte Verschmutzung die Funktion des kapazitiven Sensors nicht stören.

Eine weitere Funktion, die der hier vorgestellte Sensor abdecken soll, ist eine hohe Empfindlichkeit auf Materialien mit einem geringen εᵣ Dies wird zum Beispiel bei der Fahrzeugabsicherung gegen ungewolltes Anstoßen der Heckklappe an einer Betondecke im Parkhaus gefordert. Oder bei der Fahrzeugtürabsicherung gegen Anstoßen an eine anderes Fahrzeug oder auch an eine Glasscheibe oder Mauer.

Weiterhin sollte der Sensor sehr temperaturstabil sein, und in Anwendungen, bei denen es auf geringstem Stromverbrauch bis hin zu Anwendungen mit sehr hoher Erfassungsrate ankommt, problemlos einsetzbar sein.

Kapazitive Sensoren, die wenig auf Wasser, insbesondere salzhaltiges Wasser reagieren sollen, werden erfahrungsgemäß mit höheren Frequenzen, z.B. im MHz-Bereich betrieben. Diese Methode verursacht jedoch auch entsprechende HF-Abstrahlung, so dass hierbei oft mit kleinen Amplituden gearbeitet wird. Gleichzeitig sind kleine Amplituden im Sensorsystem natürlich auch empfindlich gegenüber HF-Einstrahlungen.

Bei einer sehr geringen eigenen EMV-Abstrahlung sollte der Sensor robust gegenüber EMV-Einstrahlung sein.

Bevorzugterweise liegen bei einem Rückschlagimpuls die hochfrequenten Spektralanteile der Flanken im GHz-Bereich. Damit ergibt sich trotz einer geringen üblichen Versorgungsspannung, eine Spannung zur Erzeugung des elektrischen Felds, die auch unter durch Feuchtigkeit erschwerten Bedingungen eine zuverlässige Objektdetektion ermöglicht.

Es ist von Vorteil, wenn die Schalteinrichtung von einem die Ansteuereinrichtung umfassenden Microcontroller einen Impuls zum Durchschalten erhält, der infolge der Induktivität zur Erzeugung des Rückschlagimpulses bestimmt und geeignet ist. Damit kann ein einzelner Impuls, ggf. auch mehrere Impulse, jeweils einzeln einen Messzyklus bestimmen. Die impulsförmige Messung mit hoher Pulsspannung führt zugleich zu einer insbesondere gegenüber EMV-Einflüssen störungsfreieren Messung.

Wenn der wenigstens einen Messelektrode wenigstens ein Schaltungselement mit nichtlinearer Kennlinie nachgeschaltet ist, kann ein Microcontroller die nach einem Rückschlagimpuls anstehende Ladung bevorzugterweise besser erfassen.

In einer bevorzugten Ausführungsform sind wenigstens zwei Kapazitäten in einer kapazitiven Brückenschaltung vorgesehen, von denen eine die Messelektrode ist. Dadurch können die von den Kapazitäten erfassten Messwerte differenziell ausgewertet werden. Temperatureinflüsse wirken auf beiden Brückenteilen gleich, sodass im Microcontroller nur die Differenz ausgewertet werden braucht.

Vorzugsweise ist von den wenigstens zwei Kapazitäten eine die Messelektrode und eine weitere Kapazität eine Differenzelektrode oder eine Kapazitätsdiode. Dies führt zu einer Differenzierung der Elektrodenmesswerte. Eine Annäherung eines Objekts an die Messelektrode lässt den Spannungswert des zugehörigen Ladungsspeichers steigen oder sinken, während gleichzeitig der Spannungswert des anderen Ladungsspeichers sinkt oder steigt.

Bei einer bevorzugten Ausgestaltung kann die Kapazitätsdiode eine steuerbare Kapazität aufweisen, um die kapazitive Brückenschaltung mittels einer Steuerspannung aus dem Microcontroller abzugleichen.

Es ist auch von Vorteil, wenn eine Erregerelektrode vorgesehen ist, die mit der wenigstens einen Messelektrode kapazitiv gekoppelt ist, da dadurch über die Erregerelektrode der Rückschlagimpuls gut eingespeist werden kann.

Vorzugsweise sind Erregerelektrode, Messelektrode und Differenzelektrode so angeordnet und beschaltet, dass eine Veränderung an der Erregerelektrode auf Messelektrode und Differenzelektrode gleich wirkt und eine etwaige Spannungsdifferenz zwischen den Ladungsspeichern nicht verändert. Dadurch lassen sich leitfähige Beläge vernachlässigen, da sie keinen Einfluss auf das Messergebnis haben.

Die Unempfindlichkeit gegenüber leitfähigen Belägen oder auch Untergründen wird vorzugsweise gesteigert, wenn die Impedanz der Erregerelektrode niederohmiger als die Impedanz von Messelektrode und Differenzelektrode ist.

Ein bevorzugter Einsatzbereich ergibt sich im Bereich von Sicherheitsleisten, wenn die Messelektrode und die Erregerelektrode als in Längsrichtung einer Sicherheitsleiste integrierte leitfähige Flächen ausgebildet sind, die über einen Abschlusswiederstand gekoppelt sind. Dadurch wird eine gegen einen leitfähige Belag unempfindliche Sicherheitsleiste geschaffen, wobei gleichzeitig eine klare Unterscheidung zwischen Annäherung eines Objekts, Druck auf die Sicherheitsleiste und Unterbrechung der Sicherheitsleiste möglich ist.

Besonders bevorzugt wird mittels wenigstens eines Ansteuersignals beim Abschalten des Stroms je ein Rückschlagimpuls erzeugt, wobei jedes Ansteuersignal jeweils eine vollständige Messung auslöst. Dadurch lässt sich zuverlässig innerhalb kürzester Zeit eine Vielzahl von unabhängigen Einzelmessungen durchführen. Damit ist besonders bevorzugt eine Vielzahl von Ansteuersignalen je Zeiteinheit möglich.

Verfahrensgemäß werden zur Erkennung der Annäherung und/oder Position wenigstens eines Objekts eine Versorgungsspannung sowie wenigstens eine Messelektrode an einem sensoraktiven Bereich bereitgestellt. Die Messelektrode wird mit einer von der Versorgungsspannung abgeleiteten Spannung angesteuert unter Erzeugung eines elektrischen Feldes ausgehend von der Messelektrode in den sensoraktiven Bereich. Eine mit der Messelektrode wirkverbundene Schalteinrichtung wird mittels der Ansteuereinrichtung zur Erzeugung des elektrischen Felds betätigt. Die von der Messelektrode gemessenen Änderungen infolge der Bewegung und/oder Anwesenheit des Objekts im sensoraktiven Bereich werden ausgewertet. Erfindungsgemäß wird infolge einer zwischen der Spannungsquelle und der Schalteinrichtung angeordneten Induktivität beim Abschalten des Stroms mittels der Schalteinrichtung ein Rückschlagimpuls mit hochfrequenten Spektralanteilen erzeugt, der eine Spannung an der Messelektrode erzeugt, die höher als die Versorgungsspannung ist. Diese Frequenzanteile durchdringen eine feuchte Verschmutzung sowie Wasser und auch salzhaltiges Wasser. Damit wird ein empfindlicher kapazitiver Annäherungs- oder Positionssensor geschaffen, der insbesondere bei geeigneter Anordnung von Erreger- und Messelektrode nicht auf Feuchtigkeit, feuchte Verschmutzung, fließendes Wasser oder ein Überwischen mit einem feuchten Lappen reagiert. Wenigstens ein Ladungsspeicher und wenigstens ein Ladungs-Ableitwiderstand sind zum temporären Erhalt der an der Messelektrode nach einem Rückschlagimpuls vorhandenen Ladung vorgesehen, damit diese Ladung zuverlässig erfasst und ausgewertet werden kann.

Bevorzugterweise wird mittels wenigstens eines Ansteuersignals der Strom zur Erzeugung je eines Rückschlagimpulses geschaltet, das jeweils eine vollständige Messung auslöst. Bedarfsweise ist eine Vielzahl von Ansteuersignalen je Zeiteinheit möglich, deren Anzahl von der Zeit zur Entladung der Induktivität nach dem Rückschlagimpuls abhängig ist. Dadurch lässt sich zuverlässig innerhalb kürzester Zeit eine Vielzahl von unabhängigen Einzelmessungen durchführen.

Weitere Vorteile ergeben sich aus den Unteransprüchen und aus der nachfolgenden Beschreibung bevorzugter Ausführungsbeispiele.

Im Folgenden wird die Erfindung an Hand von in den beigefügten Figuren dargestellten Ausführungsbeispielen näher erläutert. Es zeigen:
- Fig. 1: eine erfindungsgemäße Schaltungsanordnung mit Mess-, Differenz- und Erregerelektrode,
- Fig. 2: eine Schaltungsanordnung gemäß Fig. 1 ohne Differenzelektrode und Erregerelektrode,
- Fig. 3: eine Elektrodenanordnung einer feuchteunabhängigen Sensoreinheit im Querschnitt mit darauf befindlichem leitfähigen Belag,
- Fig. 4: die Spannungswerte der elektrischen Ladungen an den Ladungsspeichern bei einer Anordnung gemäß Fig. 3,
- Fig. 5: eine Elektrodenanordnung gemäß Fig. 3 bei Annäherung eines Fingers (Objekts),
- Fig. 6: die Spannungswerte der elektrischen Ladungen an den Ladungsspeichern bei einer Anordnung gemäß Fig. 5,
- Fig. 7: einen Ausschnitt eines Rückschlagimpulses,
- Fig. 8: eine Ausführungsform der Schaltungsanordnung gemäß Fig. 1 in Verbindung mit einer Sicherheitsleiste,
- Fig. 9: die Sicherheitsleiste mit Verschmutzung oder Wasserbelag gemäß Fig. 8 im Querschnitt,
- Fig. 10: eine alternative Anordnung der Elektroden.

### Beschreibung bevorzugter Ausführungsbeispiele

Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht. Die Erfindung wird jetzt beispielhaft unter Bezug auf die beigefügten Zeichnungen näher erläutert. Allerdings handelt es sich bei den Ausführungsbeispielen nur um Beispiele, die nicht das erfinderische Konzept auf eine bestimmte Anordnung beschränken sollen.

Folgende Darstellung bezieht sich auf eine Sensorfunktion eines Bedienelementes in Form einer kapazitiven Sensoreinrichtung, das bzw. die auch unter einer feuchten Verschmutzung, einer geschlossenen Wasserschicht oder leitfähigem Schaum noch fehlerlos funktionieren muss. Die verwendeten Transistoren müssen nicht unbedingt Feldeffekttransistoren sein, es können auch Bipolartransistoren verwendet werden.

Gemäß Fig. 1 liefert ein Microcontroller 1.1 an einen Schalttransistor 1.3 einen kurzen Impuls (Ansteuersignal 1.2) zur Durchsteuerung des Schalttransistors. Im Drain-Kreis des Schalttransistors 1.3 liegt die Induktivität 1.4. Das Ansteuersignal 1.2 ist in seiner Länge so gewählt, dass die Induktivität 1.4 magnetisch nahezu gesättigt ist. Nach dem Abschalten des Stromes entsteht ein kurzer Rückschlagimpuls 1.5, dessen Flankensteilheit durch die Spulenkapazität und parasitäre Kondensatoren bestimmt wird.

Die Güte dieses Kreises bestimmt auch die Spannungsamplitude des Rückschlagimpulses, die zum Beispiel 60 V bei einer Betriebsspannung VCC von 5 V erreichen kann. Damit ist vorteilhafterweise die Spannung an der Messelektrode infolge des Rückschlagimpulses etwa um mehr als einen Faktor 10 größer als die Versorgungsspannung 1.9. Die darin enthaltene Energie kann vorzugsweise auch als Versorgungsspannung für die Auswerteeinrichtung verwendet werden.

Fig. 7 zeigt einen Ausschnitt des Rückschlagimpulses. Bei kleiner Induktivität der Spule 1.4 von z.B. unter einem µH entsteht ein sehr kurzer Rückschlagimpuls 1.5 von z.B. nur 3 ns Breite bei z. B. der Hälfte der Pulsspannung. Dabei ist die Flankensteilheit 7.1 sehr groß und kann im spektralen Bereich mehrere GHz betragen. Diese hohen Frequenzanteile durchdringen leicht eine feuchte Verschmutzung sowie Wasser und auch salzhaltiges Wasser.

Da normalerweise zur elektronischen Auswertung eine höhere Versorgungsspannung der Auswerteelektronik als die maximale Spannung des Rückschlagimpulses benötigt wird und diese auf Grund der allgemein gebräuchlichen geringen Spannungsversorgungen von z.B. 5 V nur mit Aufwand erzeugt werden kann, dient erfindungsgemäß die hohe Spannungsspitze des Rückschlagimpulses selbst als Versorgungsspannung.

Dazu wird der Rückschlagimpuls über einem gemeinsamen Sourcewiderstand 1.7 den Source-Anschlüssen der beiden Transistoren 1.11 und 1.12 zugeführt. Zusammen bilden sie eine Brückenschaltung. Die Gate der beiden Transistoren sind über die Arbeitswiderstände 1.10 mit dem Rückschlagimpuls verbunden. Ohne eine weitere Schaltungsmaßnahme würde daher während des Rückschlagimpulses über die Drainanschlüsse der Transistoren 1.11 und 1.12 kein Strom in die Ladungsspeicher 1.13 und 1.14 fließen. Die Ladungsspeicher sind zusammen mit den Ladungs-Ableitwiderständen 1.16 so dimensioniert, dass der Microcontroller 1.1 genügend Zeit hat, die nach einem Rückschlagimpuls anstehende Ladung (bei entsprechender Gate-Beschaltung) zu erfassen. Die Kapazitätswerte der Ladungsspeicher 1.13 und 1.14 liegen im Bereich einiger pF, während die Widerstandswerte der Ableitwiderstände im Bereich von einigen zig Kilo-Ohm liegen.

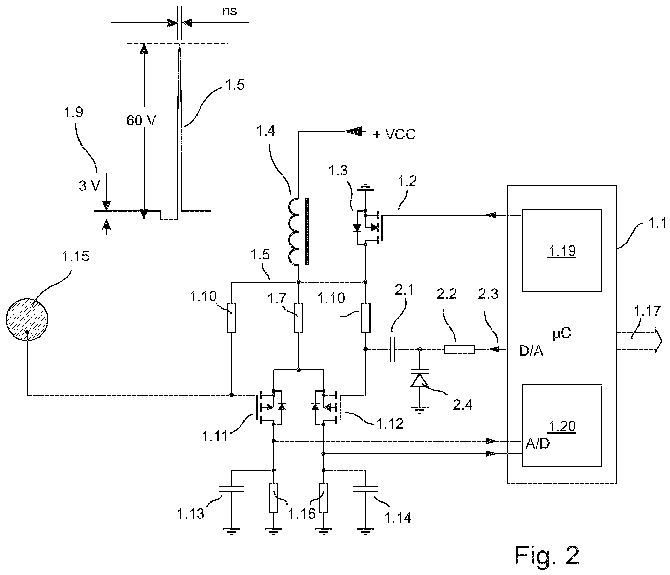

Wird nun eine Messelektrode 1.15, wie in Fig. 2 dargestellt, an das Gate des Transistors 1.11 angeschlossen, so bildet sich bei Fingerannäherung eine Kapazität gegen Masse aus. Dadurch wird Transistor 1.11 während des Rückschlagimpulses etwas leitend und überträgt einen Teil der Energie des Rückschlagimpulses 1.5 in den Ladungsspeicher 1.13. Auf Grund der Höhe des Rückschlagimpulses 1.5 kann der Spannungshub am Ladungsspeicher 1.13 durchaus 1-2 V bei einer Zunahme der Kapazität der Sensorelektrode von nur 100 Femtofarad betragen.

Anstelle der Annäherung eines Fingers 5.1 kann auch die Annäherung eines anderen Objekts im sensoraktiven Bereich 3.4 der Sensoreinheit 1.18, also eines beliebigen Gegenstands oder Lebewesens erfasst werden. Insofern wird im Folgenden das Bezugszeichen 5.1 für einen Finger und allgemein für ein Objekt verwendet.

Die kapazitive Sensoreinrichtung ist dazu bestimmt und geeignet, die Annäherung und/oder Position wenigstens eines Objekts 5.1 in einem sensoraktiven Bereich 3.4 zu erkennen. Vorgesehen ist dazu eine Spannungsquelle zum Bereitstellen einer Versorgungsspannung 1.9 und wenigstens eine Messelektrode 1.15 am sensoraktiven Bereich 3.4. Eine Ansteuereinrichtung 1.19, die Teil eines Microcontrollers 1.1 ist, dient zum Ansteuern der Messelektrode 1.15 mit einer von der Versorgungsspannung 1.9 abgeleiteten pulsförmigen Spannung unter Erzeugung eines elektrischen Feldes ausgehend von der Messelektrode in den sensoraktiven Bereich 3.4. Von der Ansteuereinrichtung 1.19 wird eine Schalteinrichtung (Schalttransistor 1.3) mit dem Ansteuersignal 1.2 betätigt, die zur Erzeugung des elektrischen Felds 3.3 mit der Messelektrode wirkverbunden ist.

Vorgesehen ist ferner eine Auswerteeinrichtung 1.20, die vorzugsweise ebenfalls Teil des Microcontrollers 1.1 ist, zur Auswertung der von der Messelektrode 1.15 gemessenen Änderungen infolge der Bewegung und/oder Anwesenheit des Objekts 5.1 im sensoraktiven Bereich 3.4.

Um den Rückschlagimpuls 1.5 zu erhalten, ist zwischen der Spannungsquelle und der Schalteinrichtung 1.3 wenigstens eine Induktivität 1.4 angeordnet. Die Ansteuereinrichtung 1.19 steuert die Schalteinrichtung 1.3 so an, dass infolge der Induktivität 1.4 beim Abschalten des Stroms der Rückschlagimpuls 1.5 mit hochfrequenten Spektralanteilen entsteht, der eine Spannung an der Messelektrode erzeugt, die höher als die Versorgungsspannung ist.

Nun ist es nicht immer ausgeschlossen, dass die Messelektrode keine parasitäre Kapazität nach Masse besitzt. Dadurch wird Transistor 1.11 möglicherweise schon etwas leitend, ohne dass z.B. eine Fingerannäherung detektiert wurde. Da ein Temperatureinfluss den Drainstrom verändern kann, wird der Sensor in Brückenschaltung betrieben. Dadurch wird bei abgeglichener Brückenschaltung ein Temperatureinfluss auf den Messwert verhindert. Den einen Teil der Brücke bildet der Transistor 1.11 der Messelektrode während der andere Brückenzweig durch einen zweiten Transistor 1.12 gebildet wird. Beide Transistoren teilen sich einen gemeinsamen Source-Widerstand 1.7. Zum Ausgleich der Brücke kann das Gate des zweiten Transistors 1.12 an eine weitere Kapazität nach Masse, an eine Messelektrode (Differenzelektrode 1.8) oder an eine weitere Kapazität, wie sie in Fig. 2 als Kapazitätsdiode 2.4 mit steuerbarer Kapazität dargestellt ist, angeschlossen werden. Dadurch ändern sich bei Temperatureinfluss beide Spannungswerte der Ladungsspeicher 1.13 und 1.14 gleich, sodass im Microcontroller 1.1 nur die Differenz ausgewertet werden braucht.

Wird das Gate des Transistors 1.12 wie in Fig. 1 mit einer Differenzelektrode 1.8 verbunden, die die Messelektrode 1.15 umgibt, so ergibt sich eine Differenzierung der Elektrodenmesswerte. Eine Annäherung eines Fingers an die Messelektrode 1.15 lässt den Spannungswert des Ladungsspeichers 1.13 steigen, während gleichzeitig der Spannungswert des Ladungsspeichers 1.14 sinkt. Die Messwerte stehen dabei immer nur direkt nach einem Rückschlagimpuls für kurze Zeit an.

Für eine sichere Vermeidung einer Fehlauslösung kann die Gesamtfläche der Differenzelektrode1.8 etwas größer als die Fläche der Messelektrode 1.15 gewählt werden. Dadurch wird gewährleistet, dass eine elektrisch leitfähige Verschmutzung, Betauung oder ein aufgelegter feuchter Lappen die Differenzelektrode mehr beeinflusst als die eigentliche Messelektrode 1.15, so dass in diesem Fall der Spannungswert am Ladungsspeicher 1.14 immer größer ist als der Spannungswert am Ladungsspeicher 1.13 der Messelektrode 1.15. Erst bei Auflegen eines Fingers auf die Fläche der Messelektrode 1.15 kehrt sich dieser Zustand um und der Spannungswert am Ladungsspeicher 1.13 der Messelektrode übersteigt den Spannungswert am Ladungsspeicher 1.14 der Differenzelektrode.

Diese Anordnung funktioniert sehr gut, wenn Messelektrode 1.15 und Differenzelektrode 1.8 nicht direkt von einer weiteren "geerdeten" Fläche umgeben sind. Kann dies nicht verhindert werden, könnte sich z.B. bei Wassereinfluss eine große Kapazität von der umgebenden geerdeten Fläche zur Differenzelektrode ausbilden, insbesondere dann, wenn die Messelektrode 1.15 nicht von dem Wasserbelag berührt wird. Eine Fingerannäherung an die Messelektrode würde in diesem Fall nicht mehr ausreichen, die Spannung am Ladungsspeicher 1.13 über die Spannung des Ladungsspeichers 1.14 der Differenzelektrode 1.8 ansteigen zu lassen.

Eine Abhilfe für diesen Fall ergibt sich durch eine, das Sensorsystem aus Mess- und Differenzelektrode umgebende Erregerelektrode 1.6. Dieser Elektrode wird der Rückschlagimpuls zugeführt.

Fig. 3 zeigt die Elektrodenanordnung einer feuchteunabhängigen Sensoreinheit 1.18 im Querschnitt. Hinter einer beliebigen nicht- oder nur schwach leitfähigen Fläche 3.1 sind Messeelektrode 1.15, Differenzelektrode1.8 und Erregerelektrode 1.6 angeordnet. Der Durchmesser der Sensoreinheit kann z.B. 30 mm betragen, nach oben sind keine Grenzen gesetzt. Oberhalb der Sensoreinheit befindet sich gestrichelt und nur schematisch angedeutet der sensoraktive Bereich 3.4, in dem die Sensoreinheit Änderungen des elektrischen Felds 3.3 z.B. in Folge der Annäherung eines Objekts wie eines Fingers 5.1 erkennen kann.

Eine günstige und platzsparende Bauform ergibt sich, wenn vorzugsweise von innen nach außen die Messelektrode 1.15, die Differenzelektrode 1.8 und dann die Erregerelektrode 1.6angeordnet werden und insbesondere, wenn sie vorzugsweise konzentrisch als Ringelektroden angeordnet sind. Eine andere Anordnung als auch Elektrodenform, z.B. eckig, rechteckig oder dergleichen ist jedoch ebenso möglich.

Auf der Fläche 3.1 befindet sich ein leicht leitfähiger Belag 3.2, zum Beispiel Schaum. Mit 3.3 sind die von der Erregerelektrode 1.6 während des Rückschlagimpulses ausgehenden elektrischen Felder dargestellt. Der leitfähige Belag 3.2 nimmt dieses elektrische Feld auf, so dass es sich nahezu homogen auf Messelektrode 1.15 und Differenzelektrode 1.8 überträgt. In diesem Fall bleiben gemäß Fig. 4 die beiden Spannungswerte 4.1 und 4.2 der elektrischen Ladungen an den Ladungsspeichern 1.13 und 1.14 gleich. Auch wenn der leitfähige Belag 3.2 nur die Differenzelektrode 1.8 erreicht, bildet sich dadurch keine Kapazität nach Masse aus, sodass sich der Messwert nicht ändert.

Erst wenn z.B. ein Finger 5.1 der Messelektrode 1.15 angenähert wird, bildet sich gemäß Fig. 5 eine Ableitung 5.2 des elektrischen Feldes aus, das sich messbar im leitfähigen Belag 3.2 befindet. An der Stelle, an der sich der Finger befindet, wird das Feld abgeschwächt. Die Abschwächung entspricht dann einer kapazitiven Wirkung des Fingers 5.1 bei einer Sensoranordnung ohne leitfähigen Belag. Dadurch verändern sich die Spannungswerte 4.1 und 4.2 der elektrischen Ladungen an den Ladungsspeicher 1.13 und 1.14 zueinander gemäß Fig. 6. Diese Veränderung kann im Microcontroller 1.1 für einen Schaltvorgang ausgewertet werden.

Befindet sich eine leitfähige Fläche, z.B. ein geerdeter oder auch nicht geerdeter metallischer Rahmen um diese Sensoreinheit 1.18 herum, so wird bei einer entsprechenden Benetzung 3.2 ein Teil des von der Erregerelektrode 1.5 ausgesandten Feldes zur umgebenden Fläche abgeleitet. Dadurch verändert sich zwar die Amplitude und gegebenenfalls die Breite des Rückschlagimpulses an der Erregerelektrode, da jedoch die Spannung der Erregerelektrode 1.6 auf Messelektrode 1.15 und Differenzelektrode 1.8 gleich einwirkt, ändert sich nichts an dem Spannungsverhältnis der Spannungswerte 4.1 und 4.2.

Weiterhin ist die Impedanz der Erregerelektrode 1.6 deutlich niederohmiger als die der Mess- oder Differenzelektrode, so dass hier bei einer kapazitiven Einwirkung auch nur kleinere Veränderungen gegenüber den Einwirkungen bei den hochohmiger angekoppelten Mess- oder Differenzelektroden auftreten.

Somit kann ein empfindlicher kapazitiver Annäherungssensor oder Schalter geschaffen werden, der auch unter starker leitfähiger Benetzung oder Verschmutzung, unter Wasser- und Salzwassereinfluss, und auch unter fließendem Wasser noch einwandfrei funktioniert. Weiterhin löst er nicht aus, wenn z.B. mit einem feuchten (leitfähigen) Lappen über die Sensoreinheit 1.18 gewischt wird.

Wird die Funktion "überwischfest" nicht gewünscht, kann der kapazitive Annäherungssensor auch nur mit einer Messelektrode 1.15 gemäß Fig. 2 betrieben werden. Dies ist z.B. bei industriellen Positionssensoren der Fall. Der zweite Zweig der Brückenschaltung, also das Gate von Transistor 1.12 kann mit einem Kondensator 2.1 entsprechend der Grundkapazität der Messelektrode 1.15 direkt nach Masse betrieben oder über eine Kapazitätsdiode 2.4 gemäß Fig. 2 nach Masse beschaltet werden. In diesem Fall kann der Microcontroller 1.1 eine Steuerspannung 2.3 für die Kapazitätsdiode 2.4 liefern, mit der bereits in der Fertigung des Sensors ein einmaliger Toleranzabgleich gemacht wird, indem z.B. die beiden Spannungen an den Ladungsspeichern 1.13 und 1.14 auf gleiche Werte eingestellt werden. Der Widerstand 2.2 dient als resistive Entkopplung der Steuerspannung 2.3 zur Kapazitätsdiode 2.4, der Kondensator 2.1 lediglich als Gleichspannungsentkopplung.

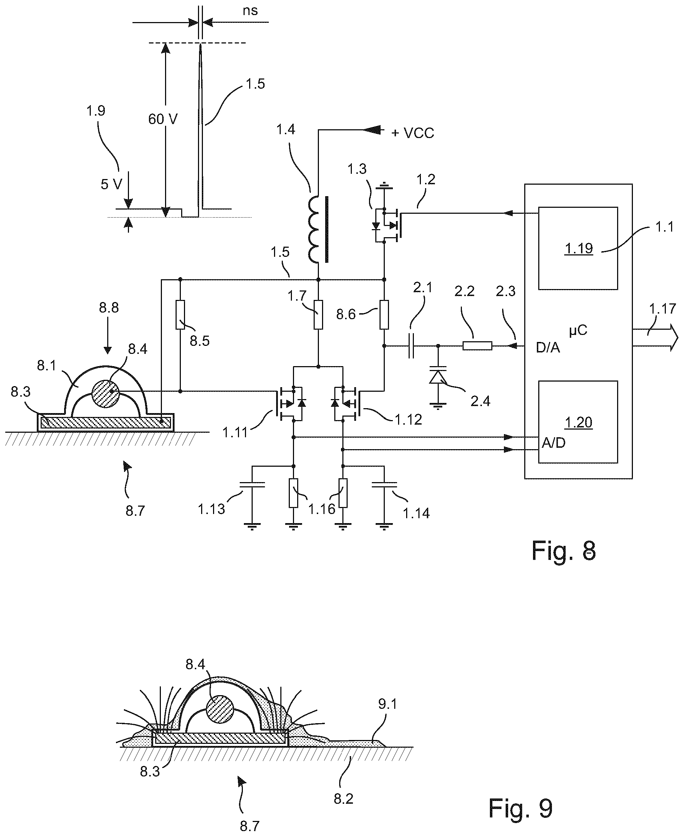

Fig.8 zeigt als weiteres Ausführungsbeispiel eine klassische taktile Sicherheitsleiste 8.7 im Querschnitt. Diese Art von Sicherheitsleisten wird als Einklemmschutz in vielerlei Anwendungen eingesetzt, z.B. an beweglichen Fenstern oder Türen oder Heckklappen im Fahrzeug oder auch bei anderen Anwendungen außerhalb des Fahrzeugbereichs, wenn es z.B. um die Überwachung von Zugangsbereichen geht.

Auf einem Trägermaterial 8.2, z.B. einem Fahrzeugchassis, ist ein Gummikörper oder ein flexibler Kunststoffkörper 8.1 der Sicherheitsleiste aufgebracht. In diesem sind zwei leitfähige Flächen 8.3 und 8.4 eingebettet, zwischen denen ein Spannungspotential anliegt. Wird ein Druck 8.8 auf die Sicherheitsleiste 8.7 ausgeübt, verformt sich die Sicherheitsleiste und die beiden leitfähigen Flächen 8.3, 8.4 kommen in Berührung. Eine Auswerteelektronik wertet den durch die Kontaktierung der beiden leitfähigen Flächen entstehenden Stromanstieg aus und kann z.B. einen Antriebsmotor stoppen oder reversieren. Um eine Unterbrechung einer der leitfähigen Flächen 8.3 oder 8.4 z.B. durch eine mechanische Beschädigung zu erkennen, wird am "Ende" der Sicherheitsleiste ein Abschlusswiderstand 8.5 angebracht. Dieser kann im Bereich von einigen hundert Ohm bis zu mehreren Kilo-Ohm betragen.

Der an der einen Seite der Sicherheitsleiste 8.7 zugeführte Strom fließt dann über eine der leitfähigen Flächen 8.3 bzw. 8.4, am Ende der Leiste über den Abschlusswiderstand 8.5 und über die andere der leitfähigen Flächen 8.4 bzw. 8.3 wieder zurück. Wird dieser über den Abschlusswiderstand geschwächte Strom überwacht, kann eine Unterbrechung der Sicherheitsleiste oder ein Kurzschluss durch Ausübung eines Drucks 8.8 detektiert werden.

Da so aufgebaute Sicherheitsleisten nur auf mechanischem Druck reagieren, also erst reagieren, wenn es fast zu spät ist und der Finger bereits eingeklemmt ist, ist eine Detektion eines Gegenstandes wünschenswert, bevor dieser die Sicherheitsleiste überhaupt berührt. Dazu kann ein kapazitiver Sensor eingesetzt werden. Nachteilig ist bei herkömmlichen kapazitiven Sensoren, dass der in der Sicherheitsleiste integrierte Abschlusswiderstand stört und entfernt werden muss, so dass die Überwachung auf Beschädigung schlecht möglich ist.

Dies ist erfindungsgemäß nicht der Fall. Bei Anschluss der Sicherheitsleiste 8.7 gemäß Fig. 8 wird der Arbeitswiderstand 1.10 gemäß Fig. 1 am Transistor 1.11 durch den Abschlusswiderstand 8.5 ersetzt. Dieser Abschlusswiderstand 8.5 ist in Fig. 8 in der Schaltung eingezeichnet, sitzt aber mechanisch am Ende der Sicherheitsleiste 8.7.

Für den Arbeitswiderstand 8.6 des zweiten Brückentransistors 1.12 wird lediglich der gleiche Wert wie der Wert des Abschlusswiderstandes 8.5 eingesetzt, um die Brückenschaltung ins Gleichgewicht zu bringen.

Da die Arbeitswiderstände in dieser Schaltungsanordnung relativ unkritisch sind, können somit Abschlusswiderstandswerte von einigen hundert Ohm bis zu mehreren Kilo-Ohm abgedeckt werden. Daher können im Markt bestehende Sicherheitsleisten ohne Modifizierung direkt verwendet werden.

Bei Annäherung an die Sicherheitsleiste 8.7 steigt die kurzzeitige elektrische Ladung 4.1 von einer Spannung von z.B. 1 V (Grundwert ohne kapazitiven Einfluss) auf höhere Werte, während bei einer Kontaktierung durch direkten Druck 8.8 die Spannung auf Null abfällt. Bei einer Unterbrechung der Sicherheitsleiste steigt die elektrische Ladung 4.1 auf einen Maximalwert an. Dadurch ergibt sich eine klare Unterscheidung zwischen Annäherung, Druck und Unterbrechung der Leiste.

Ein weiterer Vorteil bei Verwendung der Sensorschaltung zusammen mit einer Sicherheitsleiste 8.7 ergibt sich, wenn die leitfähige Fläche 8.3 als Erregerelektrode eingesetzt wird. Bei Beregnung oder Verschmutzung bildet sich gemäß Fig. 9 ein schwach bis mäßig leitfähiger Film 9.1 auf der Sicherheitsleiste 8.7 aus, der auch das möglicherweise elektrisch leitfähige Trägermaterial 8.2 oder das metallene Fahrzeugchassis erreichen kann. Die "niederohmige" Erregerelektrode bringt ihr elektrisches Feld in diesen Belag ein, sodass im Bereich der zweiten leitfähigen Fläche 8.4, also der eigentlichen Sensorelektrode, kein Potentialunterschied zum Belag entsteht.

Niederohmig bedeutet, dass ein schwach oder mäßig leitfähiger Belag zwischen Erregerelektrode und Trägermaterial 8.2 oder einer metallischen (leitfähigen) Umgebung nur geringen Einfluss auf die Impulsspannung der Erregerelektrode ausübt.

In der Praxis konnte so noch eine Annäherungsempfindlichkeit bei Handannäherung von 15 cm bei starker Beregnung und immerhin noch 5 cm unter einem direkt auf die Sicherheitsleiste gerichteten Wasserstrahl erreicht werden.

Die Anzahl der Ansteuersignale 1.2 kann je nach Anwendung beliebig gewählt werden, da jeder Takt eine komplette Messung bedeutet. Auch kann auf das zweite Brückenglied (Transistor 1.12) verzichtet werden, wenn keine Temperaturstabilität der Schaltung gefordert wird. Der Wert der Induktivität 1.4 liegt vorzugsweise unter 1 µH, um eine kurzen Rückschlagimpuls mit hoher Flankensteilheit und daher hohen Spektralanteilen zu erreichen. Der gemeinsame Source-Widerstand bestimmt die Empfindlichkeit der Sensoreinheit und beträgt vorzugsweise zwischen 220 Ohm und 1 Kilo-Ohm.

Die Kapazität der Ladungsspeicher 1.13 und 1.14 dürfen nicht zu groß gewählt werden, damit der kurze Rückschlagimpuls eine entsprechende vom Microcontroller 1.1 verwertbare Spannung aufbauen kann, und liegt vorzugsweise im zweistelligen pF-Bereich. Die Ladungs-Ableitwiderstände sind dagegen unkritisch und können einige hundert Kilo-Ohm betragen. Die Arbeitswiderstände 1.10 können bei hoher Flankensteilheit des Rückschlagimpulses klein gewählt werden, vorzugsweise im Bereich von wenigen hundert Ohm bis zig Kilo-Ohm.

In einem weiteren Ausführungsbeispiel gemäß Fig. 10 werden die wenigstens zwei Kapazitäten der Sensorvorrichtung als Slider betrieben. Die Elektroden, vorzugsweise die Messelektrode und die die Differenzelektrode, werden als Elektroden 10.1, 10.2 in einer entlang einer Bewegungsrichtung des Sliders veränderlichen Form ausgestaltet. Im Ausführungsbeispiel verjüngen sich die Elektroden und sind gegengleich angeordnet, wobei die Verjüngungen gegenläufig angeordnet sind. Vorzugsweise handelt es sich um dreieckförmige Elektroden, wobei die Spitzen dieser Dreiecke aufeinander zu zeigen. Dabei können anstelle der Dreiecke auch rautenförmige Elektroden verwendet werden. Bedarfsweise kann diese Anordnung in zeichnerisch nicht dargestellter Weise von einer Erregerelektrode 1.6 zumindest teilweise umgeben sein. Bewegt sich jetzt ein Objekt wie ein Finger 5.1 entlang dieser Elektroden, so verringert sich aufgrund der gegebenen Geometrie der Einfluss auf die eine Elektrode 10.1, während der Einfluss auf die andere Elektrode steigt oder umgekehrt je nach Bewegungsrichtung, so dass die Bewegung des Objekts erkannt werden kann.

Die Targets werden gemeinsam relativ zum Sende-/Empfangsspulensystem 1.1 entlang der Messrichtung m-m bewegt, was zu der Signatur gemäß Figur 15a führt. Die Pfeile 15.5 entsprechen dabei einzelnen Positionen des Targets. Je länger die Pfeile, desto klarer lässt sich die Position auswerten, denn desto größer ist der Rauschabstand. Bereits dadurch wird eine klare Signatur erhalten, die eine exaktere Auswertung mit höherer Sensitivität der Sensoranordnung ermöglicht, wie sie in Fig. 16 Anwendung finden

**Bezugszeichenliste**

| | | | |
|---|---|---|---|
| 1.1 | Microcontroller | 2.3 | Steuerspannung |
| 1.2 | Ansteuersignal für 1.3 | 2.4 | Kapazitätsdiode |
| 1.3 | Schalttransistor | 3.1 | elektrisch nicht leitfähige Fläche |
| 1.4 | Induktivität / Spule | 3.2 | Leitfähiger Belag |
| 1.5 | Rückschlagimpuls | 3.3 | angedeutete elektrische Felder |
| 1.6 | Erregerelektrode | 3.4 | sensoraktiver Bereich |
| 1.7 | Gemeinsamer Source-Widerstand | 4.1 | Ladung am Ladungsspeicher 1.13 |
| 1.8 | Differenzelektrode | 4.2 | Ladung am Ladungsspeicher 1.14 |
| 1.9 | Spannung der Energieversorgung | 5.1 | Finger |
| 1.10 | Arbeitswiderstand | 5.2 | Ableitung des elektrischen Feldes |
| 1.11 | Transistor der Messelektrode | 7.1 | angedeutete Flankensteilheit |
| 1.12 | Transistor der Differenzelektrode | 8.1 | Gummi- oder Kunststoffkörper von 8.7 |
| 1.13 | Ladungsspeicher der Messelektrode | | |
| 1.14 | Ladungsspeicher der Differenzelektrode | 8.2 | Trägermaterial, Fahrzeugchassis |
| | | 8.3 | erste leitfähige Fläche |
| 1.15 | Messelektrode | 8.4 | zweite leitfähige Fläche |
| 1.16 | Ladungs-Ableitwiderstände | 8.5 | Abschlusswiderstand der Sicherheitsleiste |
| 1.17 | Datenausgang | | |
| 1.18 | Sensoreinheit | 8.6 | an 8.5 angepasster Widerstand |
| 1.19 | Ansteuereinrichtung | 8.7 | Sicherheitsleiste |
| 1.20 | Auswerteeinrichtung | 8.8 | Druck |
| 2.1 | Kondensator als Gleichspannungsentkopplung | 9.1 | schwach bis mäßig leitfähiger Belag |
| | | 10.1 | Elektrode |
| 2.2 | Entkopplungswiderstand | 10.2 | Elektrode |

## Patentansprüche

1. Kapazitive Sensoreinrichtung, die dazu bestimmt und geeignet ist, die Annäherung und/oder Position wenigstens eines Objekts (5.1) in einem sensoraktiven Bereich (3.4) zu erkennen, mit:
- wenigstens einer Messelektrode (1.15) am sensoraktiven Bereich (3.4),
- einer Ansteuereinrichtung (1.19) zum Ansteuern der Messelektrode (1.15) mit einer von einer Versorgungsspannung (1.9) abgeleiteten Spannung unter Erzeugung eines elektrischen Feldes ausgehend von der Messelektrode in den sensoraktiven Bereich (3.4),
- einer von der Ansteuereinrichtung (1.19) betätigbaren Schalteinrichtung (1.3), die zur Erzeugung des elektrischen Felds mit der Messelektrode wirkverbunden ist,
- einer Auswerteeinrichtung (1.20) zur Auswertung der von der Messelektrode (1.15) erzeugten Änderungen infolge der Bewegung und/oder Anwesenheit des Objekts (5.1) im sensoraktiven Bereich (3.4),
wobei zwischen der Spannungsquelle und der Schalteinrichtung (1.3) wenigstens eine Induktivität (1.4) angeordnet ist und die Ansteuereinrichtung (1.19) dazu eingerichtet ist, die Schalteinrichtung (1.3) so anzusteuern, dass infolge der Induktivität (1.4) beim Abschalten eines Stroms durch die Induktivität mittels der Schalteinrichtung (1.3) ein Rückschlagimpuls (1.5) mit hochfrequenten Spektralanteilen entsteht,
**dadurch gekennzeichnet, dass** der Rückschlagimpuls (1.5) eine Spannung an der Messelektrode erzeugt, die höher als die Versorgungsspannung ist, und
dass der wenigstens einen Messelektrode (1.15) wenigstens ein Ladungsspeicher (1.13, 1.14) und wenigstens ein Ladungs-Ableitwiderstand (1.16) nachgeschaltet sind, die dazu bestimmt und geeignet sind, die nach einem Rückschlagimpuls (1.5) anstehende Ladung durch die Auswerteeinrichtung (1.20) eines Microcontrollers (1.1) zu erfassen.

2. Kapazitive Sensoreinrichtung nach Anspruch 1, **dadurch gekennzeichnet, dass** die hochfrequenten Spektralanteile der Flanke des Rückschlagimpulses (1.5) im GHz-Bereich liegen.

3. Kapazitive Sensoreinrichtung nach Anspruch 1 oder 2, **dadurch gekennzeichnet, dass** wenigstens zwei Kapazitäten in einer kapazitiven Brückenschaltung vorgesehen sind, von denen eine die Messelektrode (1.15) ist, und dass die Auswerteeinrichtung (1.20) dazu bestimmt und geeignet ist, die von den Kapazitäten erfassten Messwerte differenziell auszuwerten.

4. Kapazitive Sensoreinrichtung nach Anspruch 3, **dadurch gekennzeichnet, dass** die wenigstens zwei Kapazitäten so ausgebildet sind, dass
- von den wenigstens zwei Kapazitäten eine die Messelektrode (1.15) ist und eine weitere Kapazität eine Differenzelektrode (1.8) oder eine Kapazitätsdiode (2.4) ist, wobei die Kapazitätsdiode (2.4) vorzugsweise eine steuerbare Kapazität aufweist und dazu bestimmt und geeignet ist, die kapazitive Brückenschaltung mittels einer Steuerspannung aus einem Microcontroller (1.1) abzugleichen, und/oder
- sie als sich verjüngende Elektroden (10.1, 10.2) zueinander benachbart angeordnet sind, wobei die Verjüngungen gegenläufig angeordnet sind.

5. Kapazitive Sensoreinrichtung nach einem der vorhergehenden Ansprüche, **dadurch gekennzeichnet, dass** eine Erregerelektrode (1.6) vorgesehen ist, die mit der wenigstens einen Messelektrode (1.15) kapazitiv gekoppelt ist und die dazu bestimmt und geeignet ist, den Rückschlagimpuls (1.6) einzuspeisen.

6. Kapazitive Sensoreinrichtung nach Anspruch 5, **dadurch gekennzeichnet, dass** die Erregerelektrode (1.6), die Messelektrode (1.15) und die Differenzelektrode (1.8) so angeordnet und beschaltet sind, dass eine Veränderung des Rückschlagimpulses (1.5) an der Erregerelektrode auf Messelektrode (1.15) und Differenzelektrode (1.8) gleich wirkt und eine etwaige Spannungsdifferenz zwischen den Ladungsspeichern (1.13, 1.14) nicht verändert.

7. Kapazitive Sensoreinrichtung nach Anspruch 5 oder 6, **dadurch gekennzeichnet, dass** die Impedanz der Erregerelektrode (1.6) niederohmiger als die Impedanz von Messelektrode (1.15) und Differenzelektrode (1.8) ist.

8. Kapazitive Sensoreinrichtung nach einem der Ansprüche 5 bis 7, **dadurch gekennzeichnet, dass** die Messelektrode und die Erregerelektrode als in Längsrichtung einer Sicherheitsleiste (8.7) integrierte leitfähige Flächen (8.3, 8.4) ausgebildet sind, die über einen Abschlusswiederstand (8.5) koppelbar sind.

9. Kapazitive Sensoreinrichtung nach einem der vorhergehenden Ansprüche, **dadurch gekennzeichnet, dass** die Ansteuereinrichtung (1.19) dazu eingerichtet ist, die Schalteinrichtung (1.3) mittels wenigstens eines Ansteuersignals (1.2) zum Abschalten des Stroms und zur Erzeugung je eines Rückschlagimpulses (1.5) anzusteuern, das jeweils eine vollständige Messung auslöst, wobei vorzugsweise eine Vielzahl von Ansteuersignalen (1.2) je Zeiteinheit vorgesehen ist, deren Anzahl von der Zeit zur Entladung der Induktivität nach dem Rückschlagimpuls abhängig ist.

10. Verfahren zur Erkennung der Annäherung und/oder Position wenigstens eines Objekts (5.1) in einem sensoraktiven Bereich (3.4), mit den Schritten:
- Bereitstellen wenigstens einer Messelektrode (1.15) am sensoraktiven Bereich (3.4),
- Ansteuern der Messelektrode (1.15) mit einer von einer Versorgungsspannung (1.9) abgeleiteten Spannung unter Erzeugung eines elektrischen Feldes ausgehend von der Messelektrode in den sensoraktiven Bereich (3.4),
- Betätigen einer mit der Messelektrode wirkverbundenen Schalteinrichtung (1.3) mittels der Ansteuereinrichtung (1.19) zur Erzeugung des elektrischen Felds,
- Auswerten der von der Messelektrode (1.15) erzeugten Änderungen infolge der Bewegung und/oder Anwesenheit des Objekts (5.1) im sensoraktiven Bereich (3.4),
wobei infolge einer zwischen der Spannungsquelle und der Schalteinrichtung (1.3) angeordneten Induktivität (1.4) die Ansteuereinrichtung (1.19) die Schalteinrichtung (1.3) so ansteuert, dass infolge der Induktivität (1.4) beim Abschalten eines Stroms durch die Induktivität mittels der Schalteinrichtung (1.3) ein Rückschlagimpuls (1.5) mit hochfrequenten Spektralanteilen erzeugt wird,
**dadurch gekennzeichnet, dass** der Rückschlagimpuls (1.5) eine Spannung an der Messelektrode erzeugt, die höher als die Versorgungsspannung ist, und
dass wenigstens ein Ladungsspeicher (1.13, 1.14) und wenigstens ein Ladungs-Ableitwiderstand (1.16) zum temporären Erhalt der von der Messelektrode durch das Objekt erzeugbaren, nach dem Rückschlagimpuls an einem Ladungsspeicher vorhandenen Ladung vorgesehen sind und dass diese Ladung erfasst und ausgewertet wird.

11. Verfahren nach Anspruch 10, **dadurch gekennzeichnet, dass** die hochfrequenten Spektralanteile der Flanke des Rückschlagimpulses (1.5) im GHz-Bereich liegen.

12. Verfahren nach Anspruch 10 oder 11, **dadurch gekennzeichnet, dass** wenigstens zwei Kapazitäten in einer kapazitiven Brückenschaltung vorgesehen sind, von denen eine die Messelektrode (1.15) ist, um von den Kapazitäten erfasste Messwerte differenziell auszuwerten.

13. Verfahren nach Anspruch 12, **gekennzeichnet durch**
- Abgleichen der kapazitiven Brückenschaltung mittels einer Kapazitätsdiode (2.4) mit einer steuerbaren Kapazität mittels einer Steuerspannung aus einem Microcontroller (1.1) und/oder
- Anordnen der wenigstens zwei Kapazitäten benachbart zueinander als sich verjüngende Elektroden (10.1, 10.2), wobei die Verjüngungen gegenläufig angeordnet werden.

14. Verfahren nach einem der Ansprüche 10 bis 13, **dadurch gekennzeichnet, dass** der Rückschlagimpuls (1.6) mittels einer mit der wenigstens einen Messelektrode (1.15) kapazitiv gekoppelten Erregerelektrode (1.6) eingespeist wird.

15. Verfahren nach Anspruch 14, **dadurch gekennzeichnet, dass** eine Veränderung an der Erregerelektrode auf Messelektrode (1.15) und Differenzelektrode (1.8) gleich wirkt und eine etwaige Spannungsdifferenz zwischen den Ladungsspeichern (1.13, 1.14) nicht verändert.

16. Verfahren nach einem der Ansprüche 10 bis 15, **dadurch gekennzeichnet, dass** mittels wenigstens eines Ansteuersignals (1.2) der Strom zur Erzeugung je eines Rückschlagimpulses (1.5) geschaltet wird, das jeweils eine vollständige Messung auslöst, wobei vorzugsweise eine Vielzahl von Ansteuersignalen (1.2) je Zeiteinheit erfolgt, deren Anzahl von der Zeit zur Entladung der Induktivität nach dem Rückschlagimpuls abhängig ist.
